Europäisches Patentamt

European Patent Office

Office européen des brevets

(11) Publication number: **0 174 438**
**B1**

(12) **EUROPEAN PATENT SPECIFICATION**

(45) Date of publication of patent specification: **23.08.89**

(51) Int. Cl.⁴: **H 01 L 29/04, H 01 L 29/10**

(21) Application number: **85105953.5**

(22) Date of filing: **14.05.85**

(54) **Semiconductor switching device with reduced defect density.**

(30) Priority: **29.05.84 JP 109163/84**

(43) Date of publication of application:
**19.03.86 Bulletin 86/12**

(45) Publication of the grant of the patent:
**23.08.89 Bulletin 89/34**

(84) Designated Contracting States:
**DE GB SE**

(56) References cited:
**EP-A-0 008 535**
**DD-A- 74 592**
**GB-A-2 000 640**
**US-A-4 171 995**

**PATENT ABSTRACTS OF JAPAN, vol. 7, no.
251, 8th November 1983, page (E-209) (1396) &
JP-A-58-139420**

(73) Proprietor: **Kabushiki Kaisha Meidensha
1-17, Ohsaki 2-chome
Shinagawa-ku Tokyo 141 (JP)**

(72) Inventor: **Kawamura, Takayasu
Meiden Apartment B-123 4-9, Shinjuku 3-chome
Zushi-shi Kanagawa-ken (JP)**
Inventor: **Hayashi, Yasuhide
Neo Coop Totsuka 320 Nase-cho Totsuka-ku
Yokohama-shi Kanagawa-ken (JP)**

(74) Representative: **Dipl.-Phys.Dr. Manitz Dipl.-Ing.,
Dipl.-Wirtsch. Finsterwald Dipl.-Ing. Grämkow
Dipl.-Chem.Dr. Heyn Dipl.-Phys. Rotermund
Morgan, B.Sc.(Phys.) Robert-Koch-Strasse 1
D-8000 München 22 (DE)**

## Description

The present invention relates to a semiconductor device and more specifically to a gate turn-off thyristor of buried gate structure type, which can increase the controllable current (the current flowing between the anode and the cathode) and make the turned-on voltage (the voltage drop between the anode and the cathode) more uniform.

In recent years, gate turn-off thyristors (referred to as GTOs hereinafter) have been widely used in place of ordinary thyristors. This is because the GTOs can be turned off without the need to use turning-off circuits which include one or more inductors. Additionally, the GTO is high in efficiency and small in size, and further can control a high voltage and a large current as an excellent switching element. GTOs can roughly be classified into two groups of surface gate type and buried gate type on the basis of the gate structure. In the surface gate GTO, since plural gate electrodes are formed which are of complicated shape and are exposed on the device surface, it is rather difficult to reliably realize a miniaturised gate structure using the present manufacturing technique. In contrast with this, in the buried gate GTO, since the high-concentration diffusion layer used as the gate is buried in a semiconductor layer and further covered by another epitaxially-formed layer, it is relatively easy to reliably realize a miniaturised gate structure. The reason why the miniaturised gate structure is required is as follows: when the impurity atom concentration in the epitaxially formed layer is reduced, since it is possible to markedly increase the break-down voltage at the gate-cathode junction, it is possible to improve the turn-off characteristics of the GTO by applying a relatively high reverse voltage between the gate and the cathode. To further improve the turn-off characteristics, it is preferable to miniaturise the gate structure to allow the gate current to flow uniformly through the low-resistance gate layer.

In the buried gate GTO, it is further well known that when the impurity atom concentration of the diffusion layer is increased but the whole electric gate sheet resistance (determined by the total amount of dopants) is reduced to decrease the resistance of the buried gate, it is possible to obtain a large gate current, i.e. to improve the turn-off characteristics of the GTO. However, in the case where the electric gate rseistance is excessively reduced, there exists a problem in that crystal defects readily occur due to the high concentration diffusion layer. Since these crystal defects shorten the lifetime of the minority carriers in the N-type and the P-type semiconductor layers, there exists a problem in that the GTO characteristics inevitably disperse within the device and/or among the devices.

With these problems in mind, therefore, it is the primary object of the present invention to provide a semiconductor device or a gate turn-off thyristor in which the current channels formed between the high impurity atom concentration diffusion layers are so arranged that the influence of crystal defects upon the device characteristics can be minimised.

To satisfy the abovementioned object, there is provided, in accordance with the present invention, and starting from the prior art arrangement of the known buried gate GTO, a semiconductor device comprising at least three consecutive semiconductor layers of alternating conductivity types in a semiconductor wafer of isotropic material and a high impurity atom concentration control layer buried in one of said at least three semiconductor layers for controlling a switchable device current, characterised in that said at least three semiconductor layers are formed substantially in parallel with a crystal plane indicated by {100} in Miller indices; and in that a plurality of current channels are formed in said high impurity atom concentration control layer and all extend in a longitudinal direction with respect to the crystal plane of {100}, or in a plurality of longitudinal directions with respect thereto, which is, or are, substantially parallel with a respective one of the set of crystal axes indicated by <100> in Miller indices, on the condition that the inner product of that crystal axis vector and the vector direction of the selected crystal plane is zero.

Also according to the present invention there is provided a method of manufacturing a semiconductor switching device in the form of a gate turn-off thyristor, which comprises the following steps of:

(a) preparing an N-type semiconductor wafer of isotropic silicon material having an exposed crystal plane;

(b) diffusing impurity atoms on both the exposed surfaces of the prepared semiconductor wafer to form a first semiconductor layer of P-type conductivity and a second semiconductor layer of P-type conductivity;

(c) forming a pattern mask by photo-engraving on the second semiconductor layer for the forming of a high impurity concentration buried gate layer and current channels extending therein;

(d) diffusing impurity atoms on the second semiconductor layer through the formed pattern mask to form the buried gate layer and the current channels;

(e) forming a further layer of P-type conductivity semiconductor material on the second semiconductor layer and the buried gate layers by epitaxial growth;

(f) forming a pattern mask on said further layer to form a third semiconductor layer of N-type conductivity;

(g) diffusing impurity atoms on said further layer to form said third semiconductor layer of N-type conductivity;

(h) forming an anode electrode on the first P-type semiconductor layer, a gate electrode on the further layer and a cathode electrode on the third semiconductor layer, characterised in that

in step (a) the N-type semiconductor wafer is prepared to have an exposed crystal plane indicated by {100} in Miller indices; and in that in step (c) the current channels are formed in such a way that they have a longitudinal direction arranged substantially in parallel with a respective one of crystal axes indicated by <100> in Miller indices on said crystal plane, with the condition that the inner product of the direction vector of said crystal plane and of the vector specifying said crystal axis is zero.

Advantageous embodiments of the semiconductor device of the invention are set forth in the appended subordinate claims 2 to 10.

The invention results, as indicated by the underlying object, in less variation in characteristics from device to device and in improved performance by minimising the effects of defects in the crystallographic structure.

It is admittedly known from JP—A—58-139420 to manufacture an integrated circuit FET with suppressed dispersion of characteristics by appropriate selection of the orientation of the crystal wafer surface and of the alignment of the FET's with that surface. There are however various important and fundamental differences between the prior art proposal and the presently claimed proposal which clearly show that the presently claimed proposal is not obvious.

In order to form the high impurity atom concentration gate layer $P^{++}$ of the present proposal, various heat treatment processes are required and the crystal defects introduced by the high impurity atom concentration affect the channel layer, so that the lifetime of the minority carrier increases. It should be noted that although the minority carrier lifetime can be controlled (shortened) by diffusing Au into the structure, this cannot control the effects of crystal defects on the minority carrier lifetime.

Thus with the present proposal, the crystal defects occur due to the misfit dislocation caused by the difference in lattice constant between the diameter of the impurity atoms (boron, phosphorus) and that of the silicon atoms of the semiconductor crystal. It should be noted that the crystal structure of monoatomic single crystal silicon is of diamond type, that is, of isotropic type. The present proposal is based on the realisation that the current channels formed on the high impurity atom concentration diffusion layer can be arranged in such a way that the influence of crystal defects due to the heat treatment for forming the buried layer $P_2^{++}$ upon semiconductor/GTO characteristics can be minimized, due to the fact that the crystal defects distribute in certain directions crystallographically. Here, it should be noted that the GTO characteristics are the anode current and the turned-on voltage (the voltage drop between anode and cathode) and these are not controlled because the crystal defects themselves are avoided but instead by a special selection of the plane of the semiconductor wafer and of the orientation of the channels. In other words, the present proposal reduces the influence of unavoidable crystal defects by arranging the defects in a direction such that the device characteristics are not affected, while admitting that the crystal defects actually occur.

Further, in the GTO thyristor of the present application, the output current flows from the anode to the cathode in the direction perpendicular to the semiconductor layers.

In contrast, the proposal of JP—A—58-139420 is not related to a power GTO thyristor or to a buried type gate structure, but to FET's formed on a III to V family compound semiconductor IC represented by GaAs and is concerned with the direction of the orientation flat (OF) used as a basic plane for locating a wafer within various pieces of process apparatus.

In the reference, the crystal structure is of zinc-blend type which is typical of a compound represented by a chemical formula AX (two-atomic single crystal). In other words, the structure thereof is anisotropic.

The object of the reference is to arrange the orientation flat in such a way that the essential influence of anisotropy, not defects, upon FET output characteristics can be minimized in dependence upon the fact that the crystal anisotropy can be balanced in certain directions crystallographically. In other words, the dispersion of output characteristics caused by crystal anisotropy is made uniform by specially selecting the orientation of the orientation flat.

The FET characteristics of interest in the reference are the output characteristics (current and voltage between the source and the drain) and these are controllable because the dispersion of the characteristics are caused by the crystal anisotropy. In other words, the reference is concerned with reducing the influence of controllable crystal anisotropy by arranging the orientation flat in a direction such that the device characteristics are not affected, and indeed without any need to modify the conventional process apparatus. Even if an ideal crystal having no crystal defects is used, there would be the difference in output characteristics with different orientations of the flat surface (OF) due to the anisotropy of the crystal structure.

Furthermore, the output current flows from the source to the drain in parallel with the crystal wafer. Thus, the output current flows horizontally with respect to the crystal surface, so that the output current is subjected to the influence of anisotropy. In contrast with this, in the present proposal, the output current flows vertically with respect to the crystal surface, so that the output current is not affected.

The features and advantages of the semiconductor device or the gate turn-off thyristor according to the present invention over the prior art gate turn-off thyristor will be more clearly appreciated from the following description of the preferred embodiments of the invention taken in conjunction with the accompanying drawings in which like reference symbols designate the same or similar elements or sections throughout the figures thereof and in which:

Fig. 1 is a diagrammatical cross-sectional view showing a typical prior-art buried gate GTO;

Fig. 2 is a graphical representation showing the relationship between the defect density in the first N-type layer $N_1$ and the lifetime of minority carriers in the same layer $N_1$, gold being diffused in the layer $N_1$ as a lifetime shortening substance in the prior-art GTO;

Fig. 3 is a graphical representation showing the relationship between the defect density in the first N-type layer $N_1$ and the turned-on voltage (the voltage drop between anode and cathode), gold being diffused in the layer $N_1$ as lifetime shortening substance in the prior-art GTO;

Fig. 4 is a diagrammatical plane view when seen from the anode side, which shows the distribution of crystal defects in the prior-art GTO;

Fig. 5 is a plan view showing the structure of current channels CH radially arranged between the high concentration diffusion layers $P_2^{++}$ in the prior-art GTO;

Fig. 6 is a plan view showing the structure of current channels CH arranged in parallel with each other between the high concentration diffusion layers $P_2^{++}$ in a first embodiment of the GTO according to the present invention;

Fig. 7 is a graphical representation showing the relationship between the anode current and the turned-on voltage (the voltage drop between the anode and the cathode) in the form of dispersion range, in which the range defined by the solid line curve A and the dotted line curve C indicates the dispersion obtained in the prior-art GTO and the range defined by the solid line curves A and B indicates the dispersion obtained in the first embodiment of the GTO according to the present invention;

Fig. 8 is a plan view showing the structure of current channels CH arranged partially in parallel with each other between the high concentration diffusion layers $P_2^{++}$ in a second embodiment of the GTO according to the present invention; and

Figs. 9(A) to 9(D) are illustrations for assistance in explaining the manufacturing steps of a gate turn-off thyristor including four PNPN semiconductor layers of buried low-resistance layer type according to the present invention.

To facilitate an understanding of the present teaching, a reference will be made to a prior-art GTO of buried gate type, by way of example, with reference to the attached drawings.

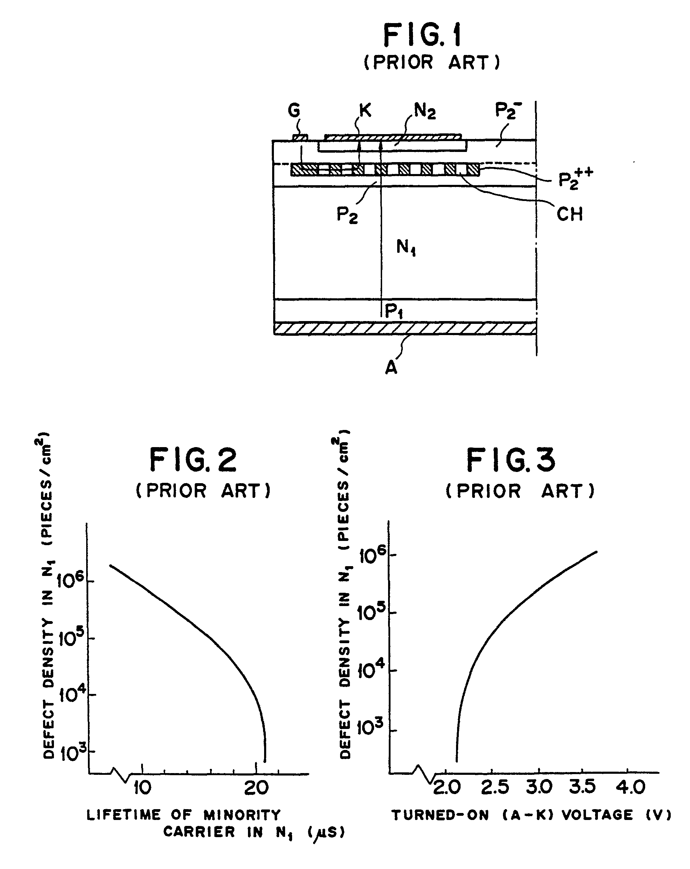

Fig. 1 is a cross-sectional view of a typical prior-art disc-shaped GTO including four PNPN semiconductor layers of buried low electric resistance layer type. The GTO includes an anode electrode A, a cathode electrode K and a gate electrode G. The four PNPN semiconductor layers are a first P-type layer $P_1$ formed in contact with the anode electrode A, a first N-type layer $N_1$ formed in contact with the first P-type layer $P_1$, a second P-type layer $P_2$, $P_2^-$ formed in contact with the first N-type layer $N_1$ and the gate electrode G, and a second N-type layer $N_2$ formed in the second P-type layer $P_2^-$ in contact with the cathode electrode K.

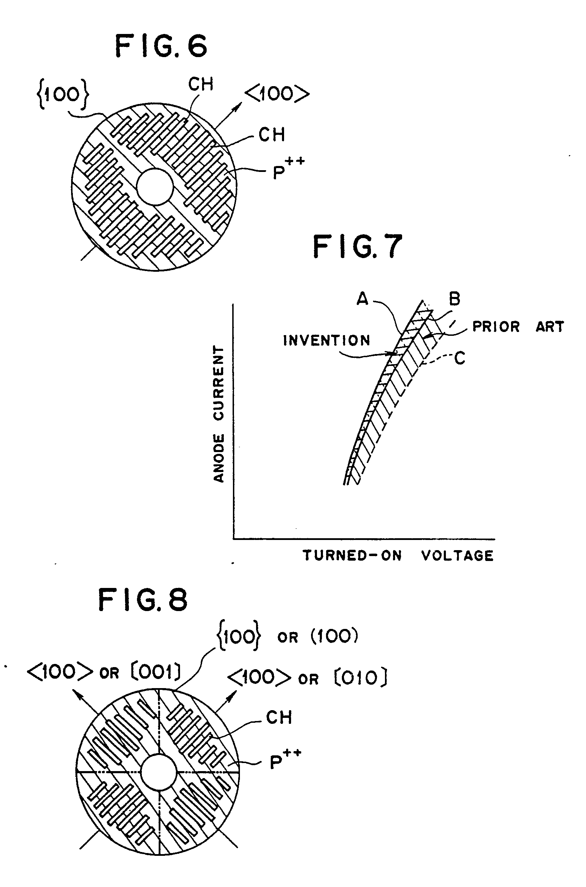

The second P-type layer $P_2$, $P_2^-$ includes a medium impurity atom concentration P-type layer $P_2$ formed in contact with the first N-type layer $N_1$, a low impurity atom concentration (high electric resistance) layer $P_2^-$ in contact with the gate electrode G and the second N-type layer $N_2$, and a high impurity atom concentration (low electric resistance) layer $P_2^{++}$ radially arranged and buried in the medium concentration layer $P_2$ and under the low concentration layer $P_2^-$. Further, as best seen in Fig. 5, a plurality of current channels CH are formed between the high concentration (low resistance) layers $P_2^{++}$.

The turn-on and turn-off operations of the GTO of buried gate type will be described hereinbelow. When a gating voltage is applied to turn on the GTO between the gate electrode G and the cathode electrode K (G: positive; K: negative) under the condition that a forward bias voltage is applied between the anode electrode A and the cathode electrode K, the gate current flows from the gate electrode G to the cathode electrode K by way of the high resistance layer $P_2^-$, the low resistance layer $P_2^{++}$, and the high resistance layer $P_2^-$. Since electrons flow from the cathode electrode K to the gate electrode G, some electrons transfer from the cathode electrode K to the anode electrode A through the current channels CH in order to turn on the GTO. When the GTO is turned on, GTO current flows from the anode electrode A to the cathode electrode K through the current channels CH formed between the low-resistance regions $P_2^{++}$ of miniaturised structure.

In contrast with this, when a reverse gating voltage is applied to turn off the GTO between the gate electrode G and the cathode electrode K (G: negative; K: positive) under the condition that an anode current flows from the anode A to the cathode K, the reverse gate current flows from the cathode electrode K to the gate electrode G by way of the high resistance layer $P_2^-$, the low resistance layer $P_2^{++}$, and the high resistance layer $P_2^-$. Since electrons flow from the gate electrode G to the cathode electrode K, electrons flowing from the cathode electrode K to the anode electrode A are reduced in order to turn off the GTO.

The crystal defect distribution in the GTO will be described hereinbelow. In the following description, braces { } denote a generic crystal plane; angle brackets < > denote a generic crystal axis; round parentheses ( ) denote a specific crystal plane; square brackets [ ] denote a specific crystal axis all being defined in accordance with Miller indices.

In the GTO as described above, when impurity atoms such as boron, phosphorus, etc. are greatly diffused into a silicon wafer cut along a generic crystal plane {100} indicated by Miller indices, since the diameter of impurity atoms (e.g. 0.88 Å or $0.88 \times 10^{-10}$ m) is much smaller than that of silicon atoms (1.17 Å or $1.17 \times 10^{-10}$ m), misfit dislocation inevitably occurs due to a difference in lattice constant. The above misfit dislocation is usually formed being arranged in the direction of a generic crystal axis <110> on the crystal plane {100}. However, the misfit dislocation has a tendency to shift in the direction of a generic crystal axis perpendicular to the axis <110> on the crystal plane {100} during impurity atom diffusion process and the succeeding heat treating process. Accordingly, in a gate turn-off thyristor, for instance, in which current channels are formed between high impurity atom concentration regions, the device characteristics deteriorate and disperse due to the misfit dislocation spreading from the high concentration regions. Since the above misfit dislocation inevitably occurs when the impurity atom concentration of the diffusion regions is increased, the problem arises that it is impossible to manufacture a GTO having a sufficient current interrupt capability.

Fig. 2 shows the relationship between the crystal defect density in the first N-type layer $N_1$ and the lifetime of the minority carrier in the layer $N_1$. This graphical representation indicates that the higher the defect density, the shorter the lifetime of the minority carrier.

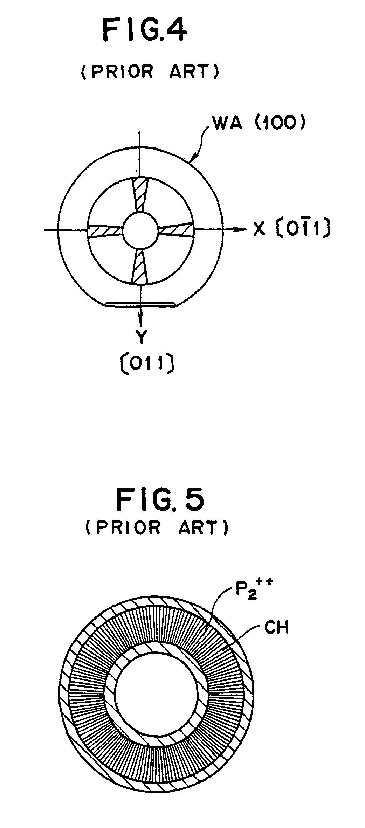

Fig. 3 shows the relationship between the crystal defect density in the first N-type layer $N_1$ and the turn-on voltage developed between the anode and the cathode when the GTO is being turned on. This graphical representation indicates that the higher the defect density, the higher the turned-on voltage.

Further, in the samples used for the above experiments, gold serving as a lifetime shortening substance is diffused at 760°C for one hour with respect to Fig. 2 and at 800°C for 30 minutes with respect to Fig. 3. The current density J is 350 A/cm² in both. Here, the current density J can be defined as I/S, where I denotes the current flowing between the anode A and the cathode K; S denotes the effective cathode area (the sum total of the current channel areas).

Fig. 4 shows an example of the crystal defect distribution of a buried gate GTO, when seen from the anode A side. The silicon wafer WA shown in Fig. 4 is cut along a specific crystal plane (100). In the drawing, the shaded portions indicates areas having a higher defect density as compared with portions other than the shaded areas. These defective portions can be known by taking only the N-type layer $N_1$ from the GTO and by emphasizing the defective areas by use of an etching agent.

Fig. 4 indicates that there exists a regularity with respect to the crystal defect distribution, that is, the areas having a higher defect density appear at angular intervals of 90 degrees or in the two directions indicated by [0$\overline{1}$1], and [011].

In orthogonal coordinates, when a first vector A has components $(a_x, a_y, a_z)$ and a second vector B has components $(b_x, b_y, b_z)$, the inner product of both the vectors A and B can be expressed as

$$A \cdot B = a_x \cdot b_x + a_y \cdot b_y + a_z b_z$$

$$\cos \theta = A \cdot B / |A| \cdot |B|$$

where

$|A|$ and $|B|$ denote absolute values of the vectors and $\theta$ denotes an angle subtended by two vectors A and B.

In Fig. 4, since the inner products of the two axes vector and the plane vector are both zero as follows:

$$(1) \times (0) + (0) \times (-1) + (0) \times (1) = 0$$

$$(1) \times (0) + (0) \times (1) + (0) \times (1) = 0$$

$$\cos \theta = A \cdot B = 0 \text{ or } \theta = 90°.$$

This indicates that the plane vector (100) is perpendicular to the axis vectors [0$\overline{1}$1], and [011] or that the two axis vectors lie on the plane.

In these high crystal defect density areas, the crystal defects spread from the high atom concentration layer $P_2^{++}$ to the anode electrode A, in the direction of the depth of the first N-type layer $N_1$, penetrating through the layer $N_1$. Further, in the case where the current channels CH or the low-resistance layer $P_2^{++}$ is arranged radially as shown in Fig. 5, it should be noted that the longitudinal directions of the current channels CH match the distribution directions in the high crystal defect density areas at angular intervals of 90 degrees. In other words, the longitudinal directions of the current channels CH are in parallel or roughly in parallel with the distribution directions of the high defect density areas in some sectorial areas. The fact that there exist high defect density areas at angular intervals of 90 degrees is a peculiar phenomenon in the case where the current channels CH are arranged on the crystal plane indicated by (100). Further, it is also possible to state that: the fact that the crystal defects spread on the crystal plane (100) is peculiar to the crystal defects. Furthermore, since the defects in the first N-type layer $N_1$ are mostly caused by the defects developed in the high atom concentration layer $P_2^{++}$, the defects appear to a greater degree on the cathode side than on the anode side within the first N-type layer $N_1$. In the areas in which the defects appear in the longitudinal direction of the first layer $N_1$, the defects also readily appear in the lateral direction thereof, a great number of defects distributing in all directions in the first layer $N_1$.

Where the above-mentioned crystal defects exist the problem arises, since the lifetime of the minority carrier is reduced in the N-type layer $N_1$, that the turned-on voltage (A—K voltage drop) increases and further the turn-on and/or turn-off characteristics are not uniform within the same device or among such devices. In particular, the controllable current flowing between the anode A and the cathode K decreases or changes in dependence upon the non-uniformity in device characteristics. Additionally, the above-mentioned crystal defect density is influenced by the manufacturing processes and/or the history of the semiconductor wafer.

In view of the above description, reference is now made to a first embodiment of the GTO according to the present invention.

Fig. 6 shows the arrangement of the current channels CH formed between the high impurity atom concentration regions $P_2^{++}$, when seen from the cathode K side. The surface is obtained by cutting a silicon wafer along a generic crystal plane indicated by {100} in Miller indices. Therefore, the generic plane {100} indicates all specific crystal planes such as (100), (010), (001); ($\overline{1}$00), (0$\overline{1}$0), and (00$\overline{1}$). The longitudinal direction of the channels CH are arranged in parallel with a generic crystal axis indicated by <100> in Miller indices. The generic axis <100> indicates all specific axes such as [100], [010], [001]; [$\overline{1}$00], [0$\overline{1}$0], and [00$\overline{1}$].

However, as already explained, since the condition that the axes lie on the plane is as follows:

Inner product of plane vector and axis vector=0

It is impossible to select all the specific axes lying on the generic plane {100} from the generic axis <100>.

For instance, if {100} is (100) and <100> is [010], [001], since all the inner products of both the vectors are zero as follows:

$$(1)\times(0)+(0)\times(1)+(0)\times(0)=0$$

$$(1)\times(0)+(0)\times(0)+(0)\times(1)=0$$

it is possible to consider that the axes [010], [001], both lie on the plane (100).

Similarly, if {100} is ($\overline{1}$00) and <100> is [010], [001], [0$\overline{1}$0], and [00$\overline{1}$], since all the inner products of both the vectors are zero as follows:

$$(-1)\times(0)+(0)\ (1)+(0)\ (0)=0$$

$$(-1)\times(0)+(0)\ (0)+(0)\ (1)=0$$

$$(-1)\times(0)+(0)\ (-1)+(0)\ (0)=0$$

$$(-1)\times(0)+(0)\ (0)+(0)\ (-1)=0$$

it is possible to consider that the above four axes all lie on the plane ($\overline{1}$00).

The above-mentioned mutual relationship between the crystal planes {100} and the crystal axes <100> has been found out on the basis of peculiar characteristics of defect density in crystal and in dependence upon a great number of experiments in order to minimize the occurrence of crystal defects.

Fig. 7 is a graphical representation showing the relationship between the anode current and the turned-on voltage (the voltage drop between the anode and the cathode). The range defined by two solid line curves A and B indicates the dispersion range obtained by measuring the GTO according to the present invention, in which the current channels CH are arranged substantially in parallel with the generic axis <100> on a wafer cut away along the generic plane {100} as shown in Fig. 6. The range defined by the solid line curve A and the dotted line curve C indicates the dispersion range obtained by measuring the prior-art GTO, in which the current channels CH are arranged radially or roughly in parallel with two specific axes [011] and [0$\overline{1}$1] on a wafer cut away along the specific plane (100) as shown in Fig. 4. The number of GTO samples is 10 pieces, respectively. The current channels are arranged in parallel to each other. The graphical representation indicates that the dispersion range of the turned-on voltage in the GTO according to the present invention can be reduced to about 1/3 as compared with that in the prior-art GTO.

Fig. 8 shows a second embodiment of the GTO according to the present invention, in which the current channels CH are arranged between the high impurity atom concentration layers $P_2^{++}$, when seen from the cathode K side. The wafer surface can be obtained by cutting a silicon crystal along the crystal plane {100} in generic expression. The channels are divided into four sections and the longitudinal directions of the channels CH are independently arranged in parallel with two axes of <100> being spaced at 90-degree angular intervals. One example of the above arrangement is as shown in Fig. 8: the crystal plane is (100); the first axis is [010]; the second axis is [001], because the inner products of the plane vector (100) and the two axis vectors are zero, respectively.

In this second embodiment, it is possible to improve the directional balance of the gate resistance on the wafer surface. Further, experiments indicate that it is possible to reduce the dispersion range of the turned-on voltage in the GTO to about 1/3 as compared with that in the prior-art GTO and additionally to increase the controllable current flowing between the anode and the cathode by as much as 20 percent.

Further, various observations have been made by emphasizing the defective areas by use of an etching agent, as already described hereinabove, in order to examine crystal defects in the first N-type layers $N_1$. The observations indicate that in the case of the prior-art GTO in which the current channels CH are formed radially as shown in Fig. 5, a great number of crystal defects appear between the buried gate areas $P_2^{++}$, and furthermore that differences in defect density exist from device to device. In contrast to this, in the case of the GTO in which the current channels CH are formed in two directions separately as shown in Fig. 8, only a small number of defects appears between the buried gate areas (low-resistanced P-type layer) $P_2^{++}$.

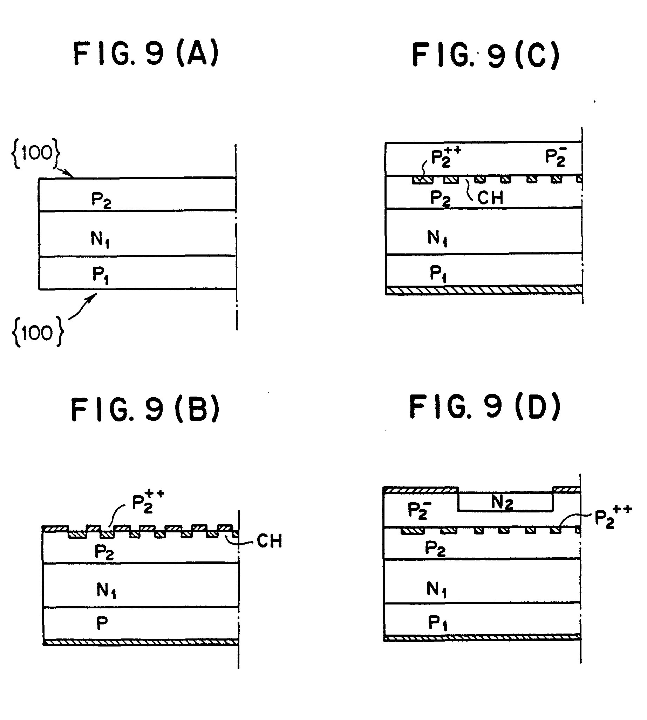

The method of manufacturing the GTO according to the present invention will be described hereinbelow with reference to Figs. 9(A), (B), (C) and (D). The manufacturing steps are as follows:

(1) Impurity atoms (e.g. gallium) are diffused by the enclosed diffusion method on both the surfaces of a negative (N-type) silicon wafer cut away along one plane of the generic crystal plane set {100} in order to form a first P-type layer $P_1$ and a

second P-type layer $P_2$. In the enclosed diffusion method, the silicon wafer and the gallium are enclosed within a quartz tube and then heated to an appropriate temperature at which the enclosed gallium is sufficiently diffused on both the surfaces of the silicon wafer.

(2) A predetermining pattern mask of silicon oxide ($SiO_2$) is formed on the surface of the second P-type layer $P_2$ using the photo engraving process and boron is selectively diffused on the layer $P_2$ at a relatively high impurity atom concentration rate in order to form the high concentration (low resistnace) P-type layer $P_2^{++}$. In this step, the pattern mask corresponding to the current channels CH is formed so that the longitudinal directions of the pattern mask is substantially in parallel with at least one of the generic crystal axes <100> on the crystal plane {100}. Further, in this step the specific crystal axes should be selected from the generic axes <100> so that the inner product of the crystal axis vector and the crystal plane vector is zero.

(3) The lower impurity atom concentration (high resistance) P-type layer $P_2^-$ is further formed on the low-resistance layer $P_2^{++}$ and the second layer $P_2$ using the epitaxial growth method by which another silicon layer is grown on a silicon monocrystal in the same crystal orientation by vapor phase epitaxy.

(4) another predetermined pattern mask of silicon oxide ($SiO_2$) is formed again on the surface of the lower concentration (high resistance) P-type layer $P_2^-$ using the photo engraving process and phosphorus (P) is selectively diffused on the surface of the layer $P_2^-$ in order to form the second N-type layer $N_2$.

(5) The anode electrode A, the cathode electrode K, and the gate electrode G are formed, respectively.

The above embodiments have been described of the GTO in which the buried gate is formed in the second P-type layer $P_2$ as shown in Fig. 1. However, without being limited to these embodiments, it is possible to apply the concept of the present invention to the GTOs in which the buried gate is formed in the first N-type layer $N_1$. Further, it is possible to apply the present invention to various devices other than the GTOs, for instance, such as static induction type transistors, thyristors, or field effect transistors, etc. in which the crystal plane {100} can be used and some controlling layers are formed within the device, in order to markedly reduce the serious influence of crystal defects upon the device characteristics.

As described above, in the GTO according to the present invention, since the semiconductor wafer is cut away along the crystal plane {100} and the current channels are so arranged as to be substantially in parallel with the axes <100> on condition that the inner product of the plane vector and the axis vector is zero, there exists an advantage such that it is possible to minimize crystal defect density on the crystal plane and thus to reduce the dispersion in the device characteristics as small as possible while increasing the controllable current markedly.

It will be understood by those skilled in the art that the foregoing description is in terms of a preferred embodiment of the present invention wherein various changes and modifications may be made without departing from the scope of the invention, as set forth in the appended claims.

## Claims

1. A semiconductor switching device comprising at least three consecutive semiconductor layers of alternating conductivity types ($P_1$, $N_1$, $P_2$) in a semiconductor wafer of isotropic material and a high impurity atom concentration control layer ($P_2^{++}$) buried in one ($P_2$) of said at least three semiconductor layers for controlling a switchable device current, characterised in that said at least three semiconductor layers are formed substantially in parallel with a crystal plane indicated by {100} in Miller indices; and in that a plurality of current channels (CH) are formed in said high impurity atom concentration control layer ($P_2^{++}$) and all extend in a longitudinal direction with respect to the crystal plane of {100}, or in a plurality of longitudinal directions with respect thereto, which is, or are, substantially parallel with a respective one of the set of crystal axes indicated by <100> in Miller indices, on the condition that the inner product of that crystal axis vector and the vector direction of the selected crystal plane is zero.

2. A semiconductor switching device as set forth in claim 1, characterised in that said at least three semiconductor layers of alternating conductivity types ($P_1$, $N_1$, $P_2$) consist of silicon.

3. A semiconductor switching device as set forth in either of claims 1 or 2, characterised in that said switching device is a gate turn-off thyristor.

4. A semiconductor switching device as set forth in either of claims 1 or 2, characterised in that said switching device is a thyristor.

5. A semiconductor switching device as set forth in either of claims 1 or 2, characterised in that said switching device is a static induction transistor.

6. A semiconductor switching device as set forth in either of claims 1 or 2, characterised in that said switching device is a field effect transistor.

7. A semiconductor switching device as set forth in claim 3, characterised in that, in manner known per se, the gate turn-off thyristor has four semiconductor layers of alternating conductivity types ($P_1$; $N_1$; $P_2$; $N_2$) comprising:
   (a) a first P-type layer ($P_1$) having an anode;
   (b) a first N-type layer ($N_1$) adjoining to the first P-type layer ($P_1$); and
   (c) a second P-type layer including:
   a first impurity atom concentration layer ($P_2$) adjoining to the first N-type layer ($N_1$);
   a second impurity atom concentration layer ($P_2^-$) adjoining to the first impurity atom concentration layer (P₂), the impurity concentration in the second impurity atom concentration layer $(P_2^-)$ being lower than the concentration in the first impurity atom concentration layer $(P_2)$; and

said high impurity atom concentration layer $(P_2^{++})$, wherein said high impurity atom concentration $(P_2^{++})$ is buried in said first impurity atom concentration layer $(P_2)$ between the first and second impurity atom concentration layers $(P_2)$ and $(P_2^-)$; and

(d) a second N-type layer $(N_2)$ formed in the second impurity atom concentration layer $(P_2^-)$ and having a cathode.

8. A semiconductor switching device as set forth in claim 7, characterised in that said high impurity atom concentration layer $(P_2^{++})$ is formed on a specific silicon crystal plane indicated by (100) in Miller indices and the longitudinal direction of the current channels (CH) is arranged substantially in parallel with a specific silicon crystal axis indicated by [010] in Miller indices on the specific silicon crystal plane (100) in Miller indices.

9. A semiconductor switching device as set forth in claim 7, characterised in that said high impurity atom concentration layer $(P_2^{++})$ is formed on a specific silicon crystal plane (100) in Miller indices and the longitudinal direction of the current channels (CH) is arranged substantially in parallel with a specific silicon crystal axis indicated by [001] in Miller indices on the specific silicon crystal plane (100) in Miller indices.

10. A semiconductor switching device as set forth in claim 7, characterised in that said high impurity atom concentration layer $(P_2^{++})$ is divided into four portions in a specific silicon crystal plane (100) in Miller indices and the current channels (CH) are grouped with their longitudinal directions being substantially in parallel with two specific silicon crystal axes indicated by [010] in Miller indices, and [001] in Miller indices on the specific silicon crystal plane (100) in Miller indices, respectively.

11. A method of manufacturing a semiconductor switching device in the form of a gate turn-off thyristor, which comprises the following steps of:

(a) preparing an N-type semiconductor wafer (WA) of isotropic silicon material having an exposed crystal plane;

(b) diffusing impurity atoms on both the exposed surfaces of the prepared semiconductor wafer to form a first semiconductor layer $(P_1)$ of P-type conductivity and a second semiconductor layer $(P_2)$ of P-type conductivity;

(c) forming a pattern mask by photo-engraving on the second semiconductor layer $(P_2)$ for the forming of a high impurity concentration buried gate layer $(P_2^{++})$ and current channels (CH) extending therein;

(d) diffusing impurity atoms on the second semiconductor layer $(P_2)$ through the formed pattern mask to form the buried gate layer $(P_2^{++})$ and the current channels (CH);

(e) forming a further layer of P-type conductivity semiconductor material $(P_2^-)$ on the second semiconductor layer $(P_2)$ and the buried gate layers $(P_2^{++})$ by epitaxial growth;

(f) forming a pattern mask on said further layer $(P_2^-)$ to form a third semiconductor layer $(N_2)$ of N-type conductivity;

(g) diffusing impurity atoms on said further layer $(P_2^-)$ to form a third semiconductor layer $(N_2)$ of N-type conductivity;

(h) forming an anode electrode (A) on the first P-type semiconductor layer $(P_1)$, a gate electrode (G) on the further layer $(P_2^-)$ and a cathode electrode (K) on the third semiconductor layer $(N_2)$, characterised in that in step (a) the N-type semiconductor wafer (WA) is prepared to have an exposed crystal plane indicated by {100} in Miller indices; and in that in step (c) the current channels (CH) are formed in such a way that they have a longitudinal direction arranged substantially in parallel with a respective one of crystal axes indicated by <100> in Miller indices on said crystal plane, with the condition that the inner product of the direction vector of said crystal plane and of the vector specifying said crystal axis is zero.

**Patentansprüche**

1. Halbleiterschalterelement mit mindestens drei aufeinanderfolgenden Halbleiterschichten $(P_1, N_1, P_2)$ abwechselnden Leitungstyps in einem Halbleiterplättchen aus isotropem Material und einer in einer $(P_2)$ der mindestens drei Halbleiterschichten eingelagerten Steuerschicht $(P_2^{++})$ mit hoher Verunreinigungsatomkonzentration zum Steuern eines schaltbaren Elementstromes, dadurch gekennzeichnet, daß die mindestens drei Halbleiterschichten im wesentlichen parallel zu einer durch {100} in Miller'schen Indizes bezeichneten Kirstallebene ausgebildet sind und daß eine Vielzahl von Stromkanälen (CH) in der Steuerschicht $(P_2^{++})$ hoher Verunreinigungsatomkonzentration ausgebildet ist, die sich alle in einer Längsrichtung bezüglich der Kristallebene {100} erstrecken, oder in einer Vielzahl von Längsrichtungen mit Bezug darauf, die im wesentlichen parallel zu jeweils einer der drei durch <100> in Miller'schen Indizes bezeichneten Kristallachsen ist bzw. sind, unter der Bedingung, daß das innere Produkt des Kristallachsenvektors mit der Vektorrichtung der ausgewählten Kristallebene Null beträgt.

2. Halbleiterschalterelement nach Anspruch 1, dadurch gekennzeichnet, daß die mindestens drei Halbleiterschichten $(P_1, N_1, P_2)$ abwechselnden Leitfähigkeitstyps aus Silizium bestehen.

3. Halbleiterschalterelement nach einem der Ansprüche 1 oder 2, dadurch gekennzeichnet, daß das Schalterelement ein über die Torelektrode abschaltbarer Thyristor ist.

4. Halbleiterschalterelement nach einem der Ansprüche 1 oder 2, dadurch gekennzeichnet, daß das Schalterelement ein Thyristor ist.

5. Halbleiterschalterelement nach einem der Ansprüche 1 oder 2, dadurch gekennzeichnet, daß das Schalterelement ein statischer Induktionstransistor ist.

6. Halbleiterschalterelement nach einem der Ansprüche 1 oder 2, dadurch gekennzeichnet, daß das Schalterelement ein Feldeffekttransistor ist.

7. Halbleiterschalterelement nach Anspruch 3, dadurch gekennzeichnet, daß in an sich bekannter Weise der über die Torelektrode abschaltbare Thyristor vier Halbleiterschichten ($P_1$; $N_1$; $P_2$; $N_2$) abwechselnden Leitfähigkeitstyps besitzt, mit:

(a) einer ersten P-Schicht ($P_1$) mit einer Anode;

(b) einer ersten N-Schicht ($N_1$), der ersten P-Schicht ($P_1$) benachbart; und

(c) einer zweiten P-Schicht, die enthält:

eine der ersten N-Schicht ($N_1$) benachbarte Schicht ($P_2$) mit erster Verunreinigungsatom-Konzentration;

eine der Schicht ($P_2$) mit erster Verunreinigungsatom-Konzentration benachbarte Schicht ($P_2^-$) mit zweiter Verunreinigungsatom-Konzentration, wobei die Verunreinigungsatom-Konzentration in der Schicht ($P_2^-$) mit zweiter Verunreinigungsatom-Konzentration geringer als die Konzentration in der Schicht ($P_2$) erster Verunreinigungsatom-Konzentration ist; und

die Schicht ($P_2^{++}$) hoher Verunreinigungsatom-Konzentration, wobei die Schicht ($P_2^{++}$) hoher Verunreinigungsatom-Konzentration in die Schicht ($P_2$) erster Verunreinigungsatom-Konzentration zwischen den Schichten ($P_2$) und ($P_2^-$) erster bzw. zweiter Verunreinigungsatom-Konzentration eingelagert ist; und

(d) einer zweiten N-Schicht ($N_2$), die in der Schicht ($P_2^-$) mit zweiter Verunreinigungsatom-Konzentration ausgebildet ist und eine Kathode besitzt.

8. Halbleiterschalterelement nach Anspruch 7, dadurch gekennzeichnet, daß die Schicht ($P_2^{++}$) hoher Verunreinigungsatom-Konzentration an einer durch (100) in Miller'schen Indizes bezeichneten bestimmten Siliziumkristallebene ausgebildet ist und die Längsrichtung der Stromkanäle (CH) im wesentlichen parallel zu einer bestimmten, durch [010] in Miller'schen Indizes bezeichneten Siliziumkristallachse angeordnet ist an der bestimmten Siliziumkristallebene (100) in Miller'schen Indizes.

9. Halbleiterschalterelement nach Anspruch 7, dadurch gekennzeichnet, daß die Schicht ($P_2^{++}$) hoher Verunreinigungsatom-Konzentration an einer bestimmten Siliziumkristallebene (100) in Miller'schen Indizes ausgebildet ist und die Längsrichtung der Stromkanäle (CH) im wesentlichen parallel zu einer bestimmten, durch [001] in Miller'schen Indizes bezeichneten Siliziumkristallachse an der bestimmten Siliziumkristallebene (100) in Miller'schen Indizes angeordnet ist.

10. Halbleiterschalterelement nach Anspruch 7, dadurch gekennzeichnet, daß die Schicht ($P_2^{++}$) hoher Verunreinigungsatom-Konzentration in vier Abschnitte in einer bestimmten Siliziumkristallebene (100) in Miller'schen Indizes unterteilt ist und die Stromkanäle (CH) mit ihren Längsrichtungen im wesentlichen parallel zu zwei bestimmten Siliziumkristallachsen gruppiert sind, welche bezeichnet sind durch [010] in Miller'schen Indizes bzw. [001] in Miller'schen Indizes, an der bestimmten Siliziumkristallebene (100) in Miller'schen Indizes.

11. Verfahren zur Herstellung eines Halbleiterschalterelementes in Form eines über die Torelektrode abschaltbaren Thyristors, mit folgenden Schritten:

(a) es wird ein N-leitendes Halbleiterplättchen (WA) aus isotropem Siliziummaterial mit einer freigelegten Kristallebene hergestellt;

(b) es werden Verunreinigungsatome in beide freigelegte Flächen des vorbereiteten Halbleiterplättchens diffundiert zur Bildung einer ersten P-leitenden Halbleiterschicht ($P_1$) und einer zweiten P-leitenden Halbleiterschicht ($P_2$);

(c) es wird durch Photo-Gravierung an der zweiten Halbleiterschicht ($P_2$) eine Formmaske zur Ausbildung einer eingelagerten Torschicht ($P_2^{++}$) hoher Verunreinigungskonzentration und sich darin erstreckender Stromkanäle (CH) ausgebildet;

(d) es werden Verunreinigungsatome durch die ausgebildete Formmask in die zweite Halbleiterschicht ($P_2$) diffundiert zur Bildung der eingelagerten Torschicht ($P_2^{++}$) und der Stromkanäle (CH);

(e) es wird eine zweite Schicht ($P_2^-$) aus P-leitendem Halbleitermaterial an der zweiten Halbleiterschicht ($P_2$) und den eingelagerten Torschichten ($P_2^{++}$) durch Epitaxie-Wachstum ausgebildet;

(f) es wird eine Formmaske an der weiteren Schicht ($P_2^-$) zur Ausbildung einer dritten N-leitenden Halbleiterschicht ($N_2$) ausgebildet;

(g) es werden Verunreinigungsatome in die weitere Schicht ($P_2^-$) zur Ausbildung einer dritten Halbleiterschicht ($N_2$) mit N-Leitung diffundiert;

(h) es wird eine Anodenelektrode (A) an der ersten P-leitenden Halbleiterschicht ($P_1$) ausgebildet, eine Torelektrode (G) an der weiteren Schicht ($P_2^-$) und eine Kathodenelektrode (K) an der dritten Halbleiterschicht ($N_2$), dadurch gekennzeichnet, daß

im Schritt (a) das N-leitende Halbleiterplättchen (WA) so vorbereitet wird, daß es eine durch {100} in Miller'schen Indizes bezeichnete freigelegte Kristallebene bestizt; und daß im Schritt (c) die Stromkanäle (CH) so ausgebildet werden, daß sie eine Längsrichtung im wesentlichen parallel zu einer jeweiligen durch <100> in Miller'schen Indizes bezeichneten Kristallachse an der Kristallebene besitzen, mit der Bedingung, daß das innere Produkt des Richtungsvektors der Kristallebene mit dem die Kristallachse bezeichnenden Vektor Null ist.

**Revendications**

1. Dispositif de commutation semiconducteur comprenant au moins trois couches semiconductrices consécutives à types de conductivité ($P_1$, $N_1$, $P_2$) alternés dans une pastille semiconductrice de matériau isotrope et une couche de commande à concentration élevée en atomes d'impureté ($P_2^{++}$)

enterrée dans l'une $(P_2)$ desdites trois couches semiconductrices, ou plus, afin de commander un courant commutable du dispositif, caractérisé en ce que lesdites trois couches semiconductrices, ou plus, sont formées sensiblement parallèlement au plan cristallin désigné par {100} en termes d'indices de Miller, et en ce que plusieurs canaux de courant (CH) sont formés dans ladite couche de commande à concentration élevée en atomes d'impureté $(P_2^{++})$ et que tous s'étendent suivant une direction longitudinale par rapport au plan cristallin {100}, ou bien suivant plusieurs directions longitudinales par rapport à celui-ci, la ou les directions étant sensiblements parallèles à un axe respectif du groupe d'axes cristallins désignés par <100> en termes d'indices de Miller, avec la condition que le produit scalaire du vecteur de cet axe cristallin et du vecteur direction du plan cristallin choisi soit nul.

2. Dispositif de commutation semiconducteur selon la revendication 1, caractérisé en ce que lesdites trois couches semiconductrices, ou plus, à types de conductivité alternés $(P_1, N_1, P_2)$ sont constituées de silicium.

3. Dispositif de commutation semiconducteur selon la revendication 1 ou 2, caractérisé en ce que ledit dispositif de commutation est un thyristor désamorçable par gâchette.

4. Dispositif de commutation semiconducteur selon la revendication 1 ou 2, caractérisé en ce que ledit dispositif de commutation est un thyristor.

5. Dispositif de commutation semiconducteur selon la revendication 1 ou 2, caractérisé en ce que ledit dispositif de commutation est un transistor à induction statique.

6. Dispositif de commutation semiconducteur selon la revendication 1 ou 2, caractérisé en ce que ledit dispositif de commutation est un transistor à effet de champ.

7. Dispositif de commutation semiconducteur selon la revendication 3, caractérisé en ce que, de manière connue, le thyristor désamorçable par gâchette possède quatre couches semiconductrices à types de conductivité alternés $(P_1; N_1; P_2; N_2)$ comprenant:

(a) une première couche de type P $(P_1)$ possédant une anode;

(b) une première couche de type N $(N_1)$ adjacente à la première couche de type P $(P_1)$; et

(c) une deuxième couche de type P comportant:

une première couche à concentration en atomes d'impureté $(P_2)$ adjacente à ladite première couche de type N $(N_1)$;

une deuxième couche à concentration en atomes d'impureté $(P_2^-)$ adjacente à la première couche à concentration en atomes d'impureté $(P_2)$, la concentration en impureté de la deuxième couche à concentration en atomes d'impureté $(P_2^-)$ étant inférieure à la concentration de la première couche à concentration en atomes d'impureté $(P_2)$; et

ladite couche à concentration élevée en atomes d'impureté $(P_2^{++})$, où ladite couche à concentration élevée en atomes d'impureté $(P_2^{++})$ est enter-

rée dans ladite première couche à concentration en atomes d'impureté $(P_2)$ entre les première et deuxième couches à concentration en atomes d'impureté $(P_2)$ et $(P_2^-)$ et

(d) une deuxième couche de type N $(N_2)$ formée dans la deuxième couche à concentration en atomes d'impureté $(P_2^-)$ et possédant une cathode.

8. Dispositif de commutation semiconducteur selon la revendication 7, caractérisé en ce que ladite couche à concentration élevée en atomes d'impureté $(P_2^{++})$ est formée sur un plan particulier, désigné par (100) en termes d'indices de Miller, du cristal de silicium, et la direction longitudinale des canaux de courant (CH) est disposée sensiblement parallèlement à un axe particulier, désigné par [010] en termes d'indices de Miller, du cristal de silicium sur le plan particulier (100) du cristal de silicium en termes d'indices de Miller.

9. Dispositif de commutation semiconducteur selon la revendication 7, caractérisé en ce que ladite couche à concentration élevée en atomes d'impureté $(P_2^{++})$ est formée sur un plan particulier, (100) en termes d'indices de Miller, du cristal de silicium, et la direction longitudinale des canaux de courant (CH) est disposée sensiblement parallèlement à un axe particulier, désigné par [001] en termes d'indices de Miller, du cristal de silicium sur le plan particulier (100) en termes d'indices de Miller du cristal de silicium.

10. Dispositif de commutation semiconducteur selon la revendication 7, caractérisé en ce que ladite couche à concentration élevée en atomes d'impureté $(P_2^{++})$ est divisée en quatre parties dans un plan particulier, (100) en termes d'indices de Miller, du cristal de silicium, et les canaux de courant (CH) sont groupés de façon que leurs directions longitudinales soient sensiblement parallèles à deux axes particuliers, désignés par [010] en termes d'indices de Miller et [001] en termes d'indices de Miller, du cristal de silicium sur le plan particulier (100) en termes d'indices de Miller du cristal de silicium, respectivement.

11. Procédé de fabrication d'un dispositif de commutation semiconducteur sous la forme d'un thyristor désamorçable par gachette, qui comprend les opérations suivantes:

(a) préparer une pastille semiconductrice de type N (WA) en matériau de silicium isotrope ayant un plan cristallin exposé;

(b) faire diffuser des atomes d'impureté sur les deux surfaces exposées de la pastille semiconductrice préparée afin de former une première couche semiconductrice $(P_1)$ à conductivité du type P et une deuxième couche semiconductrice $(P_2)$ à conductivité du type P;

(c) former une configuration de masquage par photogravure de la deuxième couche semiconductrice $(P_2)$ en vue de la formation d'une couche de grille enterrée à concentration élevée en impureté $(P_2^{++})$ et de canaux de courant (CH) s'étendant dans celle-ci;

(d) faire diffuser des atomes d'impureté sur la deuxième couche semiconductrice $(P_2)$ au travers

de la configuration de masquage formée afin de former la couche de grille enterrée (P2++) et des canaux de courant (CH);

(e) former une couche supplémentaire en matériau semiconducteur à conductivité de type P (P2−) sur la deuxième couche semiconductrice (P2) et la couche de grille enterrée (P2++) par croissance épitaxiale;

(f) former une configuration de masquage sur ladite couche supplémentaire (P2−) afin de former une troisième couche semiconductrice (N2) à type de conductivité N;

(g) faire diffuser des atomes d'impureté sur ladite couche supplémentaire (P2−) afin de former une troisième couche semiconductrice (N2) à type de conductivité N.

(h) former une électrode d'anode (A) sur la première couche semiconductrice de type P (P1),

une électrode de grille (G) sur la couche supplémentaire (P2−) et une électrode de cathode (K) sur la troisième couche semiconductrice (N2), caractérisé en ce que:

dans l'étape (a), on prépare la pastille semiconductrice du type N (WA) de façon qu'elle possède un plan cristallin exposé, désigné par {100} en termes d'indices de Miller; et

en ce que, dans l'étape (c), on forme les canaux de courant (CH) de manière qu'ils possèdent une direction longitudinale disposée sensiblement parallèlement par rapport à l'un respectif des axes cristallins désignés par <100> en termes d'indices de Miller sur ledit plan cristallin, avec la condition que le produit scalaire du vecteur directeur dudit plan cristallin et du vecteur désignant ledit axe cristallin soit nul.

# FIG.1
(PRIOR ART)

# FIG.2
(PRIOR ART)

DEFECT DENSITY IN $N_1$ (PIECES / $cm^2$)

LIFETIME OF MINORITY
CARRIER IN $N_1$ ($\mu S$)

# FIG.3
(PRIOR ART)

DEFECT DENSITY IN $N_1$ (PIECES / $cm^2$)

TURNED-ON (A–K) VOLTAGE (V)

# FIG.4

(PRIOR ART)

WA (100)

X [0$\bar{1}$1]

Y

[011]

# FIG.5

(PRIOR ART)

P$_2$$^{++}$

CH

# FIG. 6

{100}  CH  <100>  CH  P^{++}

# FIG. 7

A  B  PRIOR ART

INVENTION  C

ANODE CURRENT

TURNED-ON VOLTAGE

# FIG. 8

{100} OR (100)

<100> OR [001]  <100> OR [010]  CH  P^{++}

# FIG. 9 (A)

# FIG. 9 (C)

# FIG. 9 (B)

# FIG. 9 (D)